(19) Europäisches Patentamt / European Patent Office / Office européen des brevets

(11) **EP 2 916 460 B1**

(12) **EUROPEAN PATENT SPECIFICATION**

(45) Date of publication and mention
of the grant of the patent:
**23.08.2017 Bulletin 2017/34**

(51) Int Cl.:
*H03M 13/15* *(2006.01)*   *H03M 13/37* *(2006.01)*

(21) Application number: **15157930.7**

(22) Date of filing: **06.03.2015**

(54) **ULTRA LOW POWER CONSUMPTION (ULP) DECODER**

DECODIERER MIT EXTREM NIEDRIGER LEISTUNGSAUFNAHME

DÉCODEUR À CONSOMMATION DE PUISSANCE ULTRA FAIBLE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.03.2014 US 201461948943 P
30.12.2014 US 201414586617
24.02.2015 KR 20150025696**

(43) Date of publication of application:
**09.09.2015 Bulletin 2015/37**

(73) Proprietor: **Samsung Electronics Co., Ltd.
Gyeonggi-do 443-742 (KR)**

(72) Inventor: **Emami, Shahriar
446-712 Gyeonggi-do (KR)**

(74) Representative: **Grünecker Patent- und
Rechtsanwälte
PartG mbB
Leopoldstraße 4
80802 München (DE)**

(56) References cited:
**US-A- 6 061 823    US-A1- 2008 046 799
US-A1- 2010 017 684**

• **KIRAN BYNAM (SAMSUNG):
"Samsung's_Physical_Layer_Proposal ;
15-13-0623-00-004q-samsung-s-physical-laye
r-proposal", IEEE DRAFT;
15-13-0623-00-004Q-SAMSUNG-S-PHYSICAL-LA
YE R-PROPOSAL, IEEE-SA MENTOR,
PISCATAWAY, NJ USA, vol. 802.15 4q, 31 October
2013 (2013-10-31), pages 1-25, XP068063958,
[retrieved on 2013-10-31]**
• **KIM JEONG GON, KIM HYUNG-MYUNG:
"ADAPTIVE DECODING SCHEME FOR
CONCATENATED CODES IN
FREQUENCY-HOPPEDSPREAD-SPECTRUM
COMMUNICATIONS WITH A PULSE-BURST
JAMMING", IEICE TRANSACTIONS ON
COMMUNICATIONS, COMMUNICATIONS
SOCIETY, TOKYO, JP, vol. E79B, no. 4, April 1996
(1996-04), pages 578-586, XP000587972, ISSN:
0916-8516**
• **VAJDA I: "SIDE INFORMATION GAINED FROM
SIGNAL MATRICES IN FFH SPREAD SPECTRUM
SYSTEMS", ARCHIV FUR ELEKTRONIK UND
UBERTRAGUNGSTECHNIK, S.HIRZEL VERLAG.
STUTTGART, DE, vol. 45, no. 2, March 1991
(1991-03), pages 70-76, XP000225481, ISSN:
0001-1096**
• **FIEBIG U-C: "On the potential of FFH/MFSK
CDMA for mobile radio systems", SPREAD
SPECTRUM TECHNIQUES AND APPLICATIONS,
1998. PROCEEDINGS., 1998 IEEE 5TH
INTERNATIONAL SYMPOSIUM ON SUN CITY,
SOUTH AFRICA 2-4 SEPT. 1998, NEW YORK, NY,
USA,IEEE, US, vol. 1, 2 September 1998
(1998-09-02), pages 332-337, XP010307718, DOI:
10.1109/ISSSTA.1998.726252 ISBN:
978-0-7803-4281-1**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

One or more embodiments generally relate to efficient information decoding, in particular, to providing ultra-low power (ULP) forward error correction (FEC) decoding for variable spreading factor (VSF) ternary on-off keying (TOOK).

BACKGROUND

Wireless sensor networks (WSN) standards have been around for over a decade. The standard based designs typically experience a shorter than desired battery lifetime and large physical form factors. Conventional BCH decoding is complex and cannot be efficiently used in WSN applications.

The publication by Kiran Bynam, "Samsung's_Physical_Layer_Proposal ; 15-13-0623-00-004q-samsung-s-physical-layer-proposal", IEEE draft, IEEE-SA mentor, vol. 802.15 4q, 31 October 2013, pages 1-25 discloses a proposal for the WPAN standard, using spread spectrum communications with ternary orthogonal spreading codes called Ternary On-Off Keying (TOOK). Channel coding uses a systematic shortened BCH(63-1,51-1) code capable of correcting two errors. Demodulation accumulates signal energy over the chip sequence and compares it against a threshold, hence deciding whether a useful signal is present or not.

SUMMARY

One or more embodiments generally relate to providing ultra-low power (ULP) forward error correction (FEC) decoding for variable spreading factor (VSF) ternary on-off keying (TOOK). A method for forward error correction decoding, a receiver, and a computer-readable medium according to the invention are defined in the appended claims.

These and other aspects and advantages of one or more embodiments will become apparent from the following detailed description, which, when taken in conjunction with the drawings, illustrate by way of example the principles of the one or more embodiments.

BRIEF DESCRIPTION OF THE DRAWINGS

For a fuller understanding of the nature and advantages of the embodiments, as well as a preferred mode of use, reference should be made to the following detailed description read in conjunction with the accompanying drawings, in which:

FIG. 1 shows an example layout of a wireless sensor network (WSN).

FIG. 2 shows a block diagram of architecture for a node in a WSN, according to an embodiment.

FIG. 3 shows a block diagram of a transmitter.

FIG. 4 shows a block diagram of a receiver including a decoder, according to an embodiment.

FIG. 5 shows a decoder process flow, according to an embodiment.

FIG. 6 shows a process for information decoding, according to one embodiment.

FIG. 7 is a high-level block diagram showing an information processing system comprising a computing system implementing one or more embodiments.

DETAILED DESCRIPTION

The following description is made for the purpose of illustrating the general principles of one or more embodiments Further, particular features described herein can be used in combination with other described features in each of the various possible combinations and permutations. Unless otherwise specifically defined herein, all terms are to be given their broadest possible interpretation including meanings implied from the specification as well as meanings understood by those skilled in the art and/or as defined in dictionaries, treatises, etc.

Embodiments relate to providing power saving for providing ultra-low power (ULP) forward error correction (FEC) decoding for variable spreading factor (VSF) ternary on-off keying (TOOK). One or more embodiments may be implemented in a decoder of, for example, a receiver for a low powered device (e.g., a node in a wireless sensor network (WSN)). In one embodiment, a method includes decoding, by a receiver device, a spread spectrum coded stream of information including a multiple codeword blocks. The decoding includes determining a number of invalid codewords in a particular block of codewords. Based on a first particular number of invalid codewords in the particular block of codewords, the particular block of codewords is demapped, and parity codewords of the particular block of codewords are discarded. Based on a second particular number of invalid codewords in the particular block of codewords, a subset of syndrome components is computed using one or more coding enumerations with an update procedure for the subset of syndrome components, if all of the subset of syndrome components are zero the erroneous bit is found, otherwise enumerations continues, the particular block of codewords is demapped, and parity codewords of the particular block of codewords are discarded.

In ULP devices that rely on batteries for power, energy use cannot be taken for granted. A major part of the receiver complexity is due to the decoder (e.g., FEC decoder). In one embodiment, a decoder for error correcting codes is implemented for VSF-TOOK. In one example, the error correcting codes comprise BCH codes, which is a class of cyclic error-correcting codes that are constructed using finite fields. BCH codes were invented in 1959 by French mathematician Alexis Hocquenghem, and independently in 1960 by Raj Bose and D. K. Ray-Chaudhuri. The acronym *BCH* comprises the initials of these inventors' names. In one or more embodiments, the decoder processing is simpler as compared to a full-fledged BCH decoder. Based on the reduced decoder processing required, power consumption is reduced.

For a conventional BCH decoder: a syndrome vector that consists of 2t components is computed, where t is the error correction capability of the code; the error locator polynomial is determined (an algorithm can be used to determine the error locator polynomial coefficients, e.g., Berlekamp-Massey algorithm (finds the shortest linear feedback shift register (LFSR) for a given binary output sequence) or Peterson's algorithm (a concurrent programming algorithm for mutual exclusion that allows two processes to share a single-use resource without conflict, using only shared memory for communication); and the error location polynomial is solved (the roots of the error locator polynomial are then found through a Chien search). A fast algorithm for determining roots of polynomials defined over a finite field, typically used for finding the roots of error-locator polynomials encountered in decoding Reed-Solomon codes and BCH codes).

It has been shown that in presence of channel errors, syndrome computation, a Chien search procedure and Berlekamp-Massey procedure consume 34%, 61% and 4% of the consumed power, respectively. One or more embodiments eliminate the Berlekamp-Massey and Chien search procedures, and only the first component of the syndrome vector (25%) needs to be computed. In one example embodiment, roughly 10% of the full fledge decoding power is required, which reduces the power used for decoding by a wireless device (e.g., a WSN node device) by an order of magnitude.

The document US 2008/046799 A1, Geller Benoit et al., 21 February 2008, discloses a fast Chase decoding algorithm used for decoding a BCH code, for use within a SISO turbo decoding method. Test patterns are obtained by exhaustive flipping of least reliable bits. Syndrome computation is made efficient by Gray ordering the test patterns, so that successive test patterns differ by one bit only and an updated syndrome can be obtained by by adding to the preceding syndrome a column of the parity check matrix corresponding to the position of the differing bit, instead of re-computing the syndrome.

The publication of Kim Jeong Gon, Kim Hyung-Myung: "Adaptive Decoding Scheme for Concatenated Codes in Frequency-Hopped Spread-Spectrum Communications with a Pulse-Burst Jamming", IEICE Transactions on Communications, vol. E79B, no. 4, April 1996, pages 578-586, discloses a frequency hopping spread spectrum communications system.

Channel coding uses a concatenation of an inner-BCH code and an outer Reed-Solomon code. At the receiver, jammed bits are marked with erasure flags. If the number of erasures is larger than a threshold, the information bits of the BCH inner code are marked as erasures for RS decoding. Otherwise, error and erasure correction is carried out.

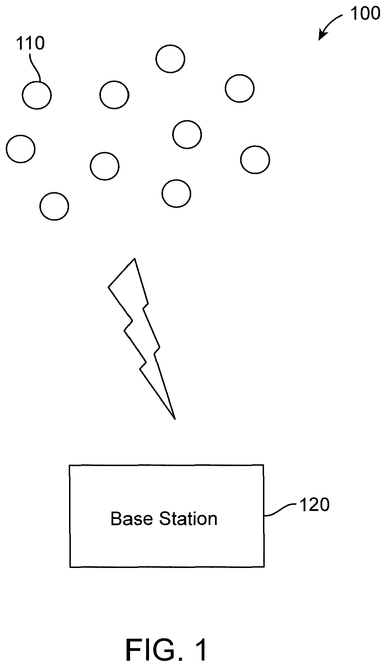

FIG. 1 shows an example layout of a WSN 100, for implementation of an embodiment. In one example, the WSN 100 includes multiple nodes 110 and a base station 120. The base station 120 may comprise a mobile device (e.g., smart phone, camera, content player, video recorder, tablet, wearable device, etc.), a personal computer, a server device, cloud based server, a smart device (e.g., smart TV, etc.), etc.

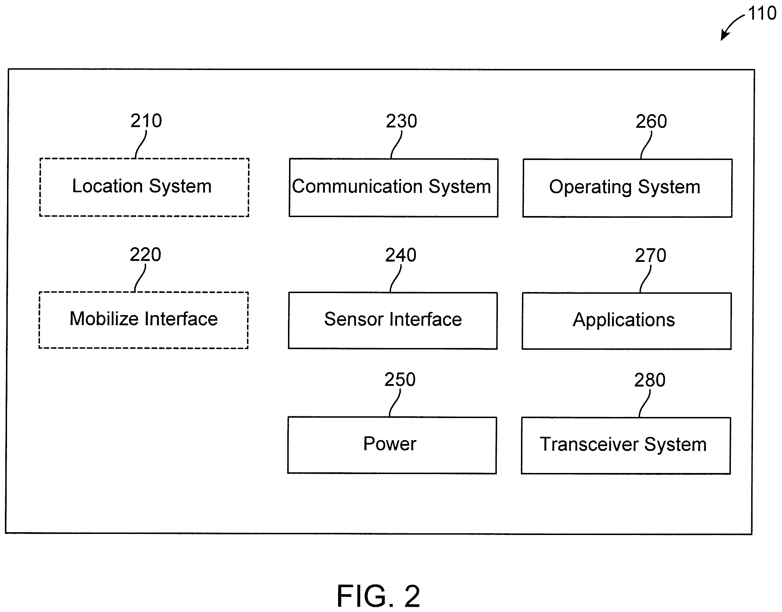

In one example, the nodes 110 may provide spatially distributed autonomous sensors for monitoring conditions (e.g., physical, environmental conditions, such as temperature, sound, pressure, etc. and to cooperatively pass their data through the network to the base station 120. In another example, the nodes 110 are bi-directional, and may control sensor activity. In one example, the nodes 110 may number anywhere from a few to several hundred, or even thousands, where each node is connected to one or more sensors (e.g., sensor 240, FIG. 2). Some further examples of use cases for WSN 100 may include: forest fire detection, flood detection, air and water pollution, bio-complexity mapping, precision agriculture, telemonitoring of physiological data, tracking and monitoring patients, doctors, etc. in a hospital, drug administration, smart environments, home and office automation, vehicle applications (e.g., remote monitoring, remote inspection, vehicle tracking, etc.), inventory control, acoustic monitoring, motion detection, etc.

The size and cost constraints on nodes 110 result in corresponding constraints on resources, such as energy, memory, computational speed and communications bandwidth. The topology of the WSN 100 may vary from a star network to a multi-hop wireless mesh network.

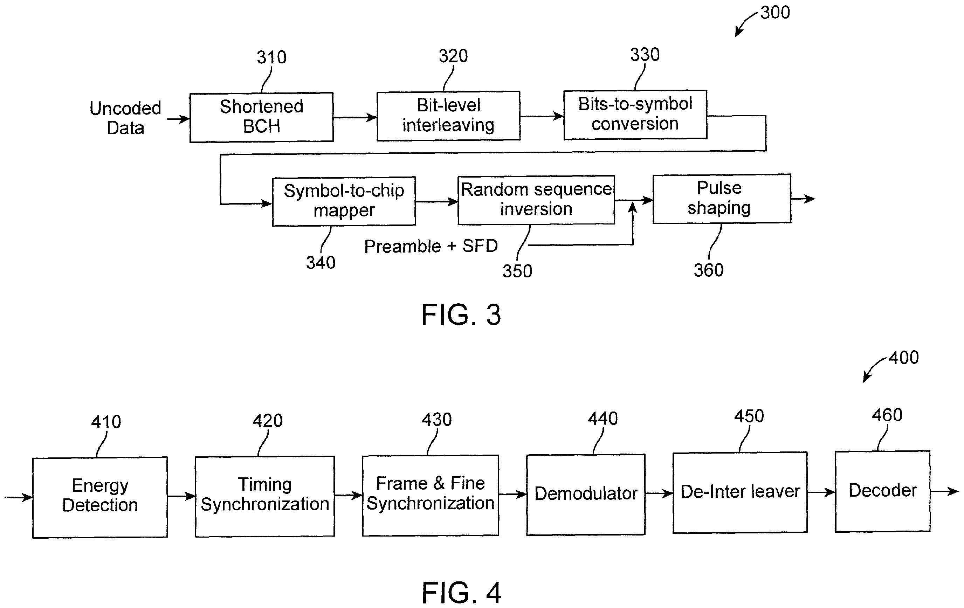

FIG. 2 shows a block diagram of architecture for a node 110, according to an embodiment. In one example, the node 110 includes a location system 210, a mobilizer interface 220, a communication system 230, sensor interface 240, a power unit 250, an operating system 260, one or more applications 270 and a transceiver system 280 (that includes a receiver 400 (FIG. 4), and which may or may not include a transmitter).

The location system 210 is responsible for finding location of the node 110 and providing drivers for the location finding instruments if they are present on the node 110 (e.g., global positioning system (GPS) sensor/system, distance processing, etc.). The mobilizer interface 220 is responsible for a mobilizer driver, and controlling of a mobilizer (e.g., for moving the node 110). The mobilizer interface 220 may be optional and is included if the node 110 has a mobilizer in it.

The communication system 230 is responsible for the route set up, channel allocation, new node detection, route table maintenance, encryption/decryption of the data, providing other security features as required, providing good quality of service (QoS), error checking and correction, data buffering, data forwarding, etc. In one embodiment, communications system 230 circuitry may include any suitable communications circuitry operative to connect to a communications network (e.g., WSN 100, FIG. 1) and to transmit communications and data from the node 110 to other devices within the communications network (e.g., the base station 120). Communications circuitry may be operative to interface with the communications network using any suitable communications protocol such as, for example, Wi-Fi (e.g., an IEEE 802.11 protocol), BLUETOOTH®, ZIGBEE®, etc.

The operating system (OS) 260 may include hardware common microcode that is used by all other high-level node 110 resident interfaces and modules. The purpose of OS 260 is to shield the higher level interfaces and modules from machine level functionality of a microprocessor or processor. In one example, the OS 260 includes a tiny-OS, which is open source software designed particularly for WSNs. The sensor interface 240 is responsible to provide drivers to sensors present in the node 110, to collect data from a sensor when generated, to switch one or more sensors on and off, configure the sensors, and any other function that is related to sensors. The sensors connected to the sensor interface 240 may be included on the node 110 or external to the node 110. In one embodiment, the node 110 may include one or more sensors or connect to one or more sensors. The sensors may include accelerometer, gyroscope, microphone, temperature, light, barometer, magnetometer, compass, radio frequency (RF) identification sensor, etc.

Sensors are hardware devices that produce a measurable response to a change in a physical condition, such as temperature or pressure. Sensors may measure physical data of the parameter to be monitored. The continual analog signal produced by the sensors is digitized by an analog-to-digital converter and sent to controllers for further processing. Sensors may be grouped into categories, such as passive, omni-directional sensors, narrow-beam sensors, and active sensors. Passive sensors sense the data without actually manipulating the environment by active probing. Passive sensors are self-powered, that is, energy is needed only to amplify their analog signal. Active sensors actively probe the environment and require continuous energy from a power source. Narrow-beam sensors have a defined notion of direction of measurement, similar to a camera. Omni-directional sensors have no notion of direction involved in their measurements. Each node 110 has a particular area of coverage for which it may reliably and accurately report the particular quantity of data that it is sensing. Several sources of power consumption in sensors are: signal sampling and conversion of physical signals to electrical ones, signal conditioning, and analog-to-digital conversion.

In one example, the node 110 includes memory that may include, for example, cache, Flash memory, ROM, and/or RAM/DRAM. In some embodiments, memory may be specifically dedicated to storing firmware (e.g., for device applications such as an operating system, user interface functions, and processor functions). Memory may be operative to store information related to other devices with which the node 110 performs communications operations (e.g., saving contact information related to communications operations or storing information related to different media types and media items selected by the user).

The applications interface 270 is responsible for data aggregation, in node processing and any other application specific functions. The power unit 250 includes a source of power for the node 110. The source of power may include battery power, capacitors, a charging unit (e.g., solar, energizing solutions, etc.). The node 110 consumes power for sensing, communicating and data processing. Batteries, both rechargeable and non-rechargeable, are the main source of the power source for the node 110. Batteries are classified according to electrochemical material used for the electrodes, such as NiCd (nickel-cadmium), NiZn (nickel-zinc), NiMH (nickel-metal hydride), and lithium-ion. Some sensors may be able to renew their energy from solar sources, temperature differences, or vibration. The power unit 250 may include power saving policies, such as Dynamic Power Management (DPM) and Dynamic Voltage Scaling (DVS). DPM conserves power by shutting down parts of the node 110 that are not currently used or active. A DVS scheme varies the power levels within the node 110 depending on the non-deterministic workload.

The transceiver system 280 is used for processing received information and sending information. The transceiver system includes the receiver 400 (FIG. 4) that receives coded information and decodes the received information, and for transmitting data obtained from the sensor(s).

FIG. 3 shows a block diagram of a transmitter 300. The transmitter 300 includes specialized processing hardware and interfaces, including: shortened BCH code processing 310, bit-level interleaving 320, bits-to-symbol conversion 330, symbol-to-chip mapper 340, random sequence inversion 350 and pulse shaping 360. The preamble and start frame delimiter (SFD) for an Ethernet frame are added between the random sequence inversion 350 and the pulse shaping 360.

While BCH coding is described, one or more embodiments may include other coding in place of the shortened BCH 310 coding for using optimized decoding by the decoder 460 (FIG. 4). BCH codes form a class of cyclic error-correcting codes that are constructed using finite fields. One of the features of BCH codes is that during code design, there is precise control over the number of symbol errors correctable by the code. It is possible to design binary BCH codes that can correct multiple bit errors. BCH codes may be decoded via syndrome decoding.

Pulse-position modulation (PPM) is a form of signal modulation in which M message bits are encoded by transmitting a single pulse in one of $2^M$ possible time-shifts. This is repeated every T seconds, such that the transmitted bit rate is M/T bits per second.

One or more embodiments use a physical layer (PHY), VSF-TOOK, where the bit stream is initially protected with a FEC BCH code. A single bit or a number of bits are mapped into spreading codewords or sequences. On-off keying (OOK) chip modulation with Gaussian pulse shaping is used by the transmitter 300.

In one example embodiment, the bit stream is encoded by the transmitter 300 using (63,51) BCH code. The bits '0' and '1' are mapped into '10' and '01' codewords, respectively, as seen in Table 1 below.

Table 1.

| Input | Output |
|-------|--------|
| 0 | 10 |
| 1 | 01 |

OOK modulation is employed to transmit information from the transmitter 300 to a receiver (e.g., receiver 400, FIG. 4). After the transmitter transmits encoded information, the bits are recovered and routed to the decoder 460 of the receiver 400 (FIG. 4).

FIG. 4 shows a block diagram of a receiver 400 including a decoder 460, according to an embodiment. Forward error correction is an extremely useful functionality, but its implementation requires some complexity. In one example embodiment, the decoder 460 decodes codes (e.g., BCH codes or other codes) for VSF-TOOK. The PHY receiver may further include interfaces and processing for energy detection 410, timing synchronization 420, frame and fine synchronization 430, demodulator 440, and de-interleaver 450 in addition to the decoder 460.

OOK denotes a simple form of amplitude-shift keying (ASK) modulation that represents digital data as the presence or absence of a carrier wave. The presence of a carrier for a specific duration represents a binary one, while its absence for the same duration represents a binary zero. Other schemes may vary these durations to convey additional information. In one example embodiment, the possible received codewords are '10', '01', '11' and '00'. In one example, received codewords '10' and '01' are considered valid. Received codewords '11' or '00' are considered as invalid, and signal occurrence of a channel error. In this example, the BCH coded data bits, encoded spread spectrum coded stream, received spread spectrum coded stream (w/o error) and received spread spectrum coded stream (w/ error) are provided below:

```
BCH coded bits
0        1        1        0        ...
Spread spectrum coded stream
10       01       01       10       ...
Received spread spectrum coded stream (w/o error)
10       01       01       10       ...
Received spread spectrum coded stream (with error)
10       11       01       10       ...
```

In a conventional BCH decoder, the received chip stream is demapped into a bit stream, and the bit stream is decoded by a conventional BCH decoder in three steps. First, the syndrome vector consisting of $2t$ components is computed where t is the error correction capability of the code. Then, the error locator polynomial is determined. Finally, the error location polynomial is solved. Berlekamp-Massey or Peterson's algorithm can be used to determine the error locator polynomial coefficients. The Berlekamp-Massey algorithm is conventionally more popular as it is less complex. The roots of the error locator polynomial are then found through a search procedure, conventionally known as a Chien search. The full-fledged conventional decoding procedure comprised of syndrome vector determination, finding the error locator polynomial coefficients and solving the error locator polynomial equation is quite complex. Conventionally, syndrome computation and the Chien search procedure consume far more power as compared to a Berlekamp-Massey procedure.

One or more embodiments provide a way to lower the complexity of a conventional decoder. In one embodiment, the error location may be determined by the presence of invalid codewords, which reduces the computational complexity as compared to a conventional BCH decoder. In one example, the decoder 460 counts the number of invalid codewords within the systematic portion of the codeword (e.g., a BCH codeword). If a first particular there are no (i.e., zero (0)) invalid codewords, a conventional decoder (e.g., a conventional BCH decoder) is utilized to correct any errors undetected by this approach. If, however, the number of the invalid codewords are greater than a first particular number (e.g., two (2), which is beyond the error correction capability of a (63, 51, 2) code), then the decoder 460 processes the chip stream and demaps the chip stream into a bit stream, and the parity portion is discarded. If there is a second particular number for invalid codewords (e.g., either a single error or two errors within the block), instead of performing a Chien search, in one embodiment the decoder 460 processing is performed, and requires computing a subset of syndrome components computation. In other words, the complexity would be $2/2t$ of the conventional syndrome vector calculations.

In one example embodiment, it is established that roughly a single component syndrome computation is sufficient to correct errors when using (63, 51, 2) BCH code. It is known that in the absence of bit errors in a code block all $2t$ components of a syndrome vector are zero. It can be shown that single error or double error events do not lead to $S_1=S_3=0$, where S is a syndrome vector. As such, an $S_1=S_3=0$ condition may be used to detect an error-free event, if error-free, single error and double error event are the only possible events.

The parity check matrix of a BCH code of length n (where n is a positive integer), information size of $k$ bits (where k is a positive integer) and error correction capabity of t (where t is a postive integer) are errors denoted by *(n, k, t)* and is given by

$$H = \begin{bmatrix} 1 & \cdots & \alpha^{n-1} \\ \vdots & \ddots & \vdots \\ 1 & \cdots & (\alpha^{2t})^{n-1} \end{bmatrix}$$

where $\alpha$ is the primitive element of a Galois field(GF) $(2^m)$ and m = $log_2(1+n)$ (where *m* is a positive integer). The codeword polynomial associated with each and every code word c is

$$c = c_0 + c_1 x + c_2 x^2 + \cdots + c_{n-1} x^{n-1}$$

(where x is a positive integer). For each and every codeword, as per definition,

$$H.c^T = 0$$

*(where H* is a matrix). Upon substitution for both H and c, we end up with

$$c_0 + c_1(\alpha^j) + c_2(\alpha^j)^2 + \cdots + c_{n-1}(\alpha^j)^{n-1} = 0, j = 1,2,\ldots,2t.$$

The syndromes vector associated with a received code vector, consisting of *2t* syndromes, is defined as:

$$[S_1 \ S_2 \ \ldots \ S_{2t}]^T = Hr^T$$

where r is the received polynomial. In presence of *v* errors in location $u_1$, $u_2$, ..., $u_v$, syndromes may be written as

$$S_j = \alpha^{u_1 j} + \alpha^{u_2 j} + \cdots + \alpha^{u_v j}.$$

For instance the first component of the syndrome vector are

$$S_1 = \alpha^{u_1}$$

and

$$S_1 = \alpha^{u_1} + \alpha^{u_2}$$

subject to single ($t$=1) and double errors ($t$=2), respectively. Subject to Gray coding (Gray code is a binary numeral system where two successive values differ in only one bit (binary digit)) enumeration, succesive syndromes are related through:

$$S_{j,new} = S_j + \alpha^{u_{pj}}$$

where p denotes the error position where two succesive codes differ. As such, in one embodiment, instead of computing a brand new syndrome every time, the decoder 460 performs a single processing operation that is sufficient to update the syndrome component. An example for syndrome update procedure is provided below in Table 2.

Table 2.

| (ul,u2) | $S_1$ |
|---------|-------|
| (0, 0) | Compute $S_1$ based on the definition |
| (1,0) | $S_{1,2}=S_1+\alpha^{u1}$ |
| (1,1) | $S_{1,3}= S_{1,2}+\alpha^{u2}$ |
| (0,1) | $S_{1,4}= S_{1,3}+\alpha^{u1}$ |

In one embodiment, the complexity associated with multiple error correction processing will be roughly equivalent to a single syndrome computation as long as

$$2^v \ll n.$$

In one embodiment, the process for decoder 460 starts off with, for example, an all zero input bit combination. This bit combination is inserted in the received codeword, and the syndrome components $S_1$ and $S_3$ associated with the received codeword is determined. If $S_1$ and $S_3$ turn out to be zero, the correct bits are found. Otherwise, the successive Gray code combination is inserted in the received codeword and the $S_1$ and $S_3$ associated with this received code is determined. The updated rule for $S_1$ and $S_3$ is used instead of determining it from scratch. If $S_1$ and $S_3$ turn out to be zero, the correct bits are found. Otherwise, the decoder 460 processing continues until the correct bit combination is found.

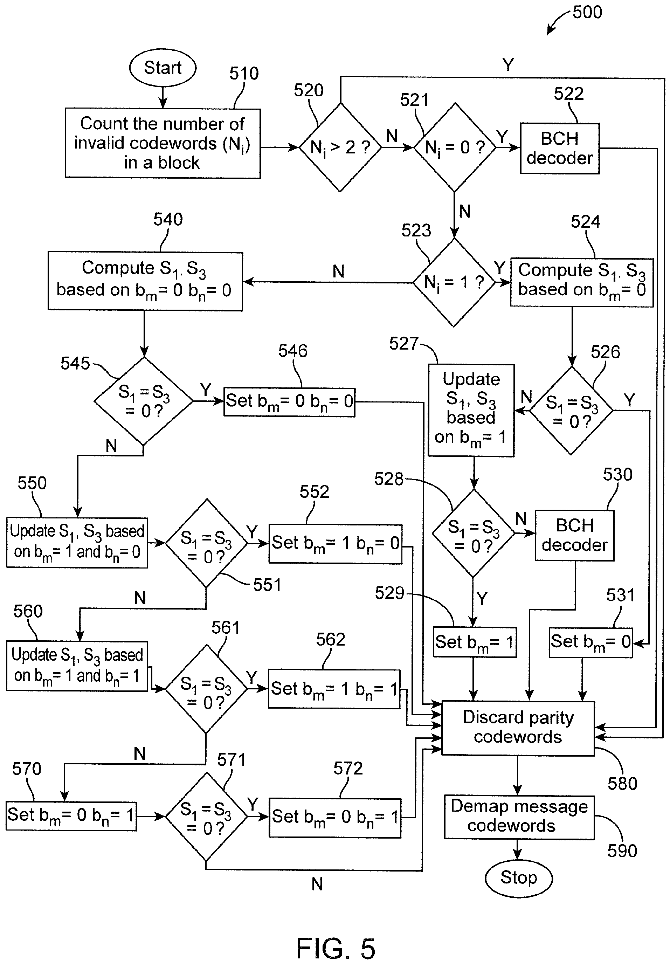

FIG. 5 shows a decoder 460 (FIG. 4) process 500 flow, according to an embodiment. In one embodiment, process 500 begins with block 510 where the number of invalid codewords ($N_i$) is counted within a codeword block. Process 500 proceeds to block 520 where it is determined whether the number of invalid codewords $N_i$ exceeds a first particular number (e.g., two (2)). If it is determined that the number of invalid codewords $N_i$ is greater than the first particular number (e.g., two (2)), process 500 continues to block 580 where the parity codewords are discarded. Process 500 continues to block 590 where message codewords are demapped and the decoding process 500 then ends.

If it is determined in block 520 that the number of invalid codewords $N_i$ is not greater than the first particular number (e.g., two (2)), process 500 proceeds to block 521 where it is determined whether the number of invalid codewords $N_i$ is equal to a third particular number (e.g., zero (0)). If it is determined in block 521 that the number of invalid codewords $N_i$ is equal to the third particular number (e.g., zero (0)), the process 500 proceeds to block 522 where a conventional decoder (e.g., a conventional BCH decoder) processes the block of codewords, and then process 500 proceeds to blocks 580, and then to block 590.

If it is determined in block 521 that the number of invalid codewords $N_i$ is not equal to the third particular number (e.g., zero (0)), process 500 proceeds to block 523. In block 523, it is determined whether the number of invalid codewords $N_i$ is equal to a second particular number (e.g., one (1)). If it is determined in block 523 that the number of invalid

codewords $N_i$ is equal to the second particular number (e.g., one (1)), process 500 proceeds to block 524 where the syndromes $S_1$ and $S_3$ are computed based on $b_m = 0$ (where b is a binary digit, and m is a positive integer). Process 500 continues to block 526 where it is determined whether $S_1$ and $S_3$ are equal to zero (0). If it is determined in block 526 that $S_1$ and $S_3$ are equal to zero (0), process 500 continues to block 531 where $b_m$ is set equal to zero (0), and process 500 continues to block 580 and then to block 590.

If it is determined in block 526 that $S_1$ and $S_3$ are not equal to zero (0), process 500 continues to block 527 where $S_1$ and $S_3$ are updated based on $b_m$ being equal to one (1). Process 500 continues to block 528 where it is determined whether $S_1$ and $S_3$ are equal to zero (0). If it is determined in block 528 that $S_1$ and $S_3$ are not equal to zero (0), then process 500 proceeds to block 530 where the conventional decoder (e.g., a conventional BCH decoder) is used to process the codeword block, and process 500 then continues to block 580 and then to block 590. If it is determined in block 528 that $S_1$ and $S_3$ are equal to zero (0), then process 500 proceeds to block 529 where $b_m$ is set equal to 1, and process 500 continues to block 580 and then to block 590.

If it is determined in block 523 that the number of invalid codewords $N_i$ is not equal to the second particular number (e.g., one (1)), process 500 proceeds to block 540 where $S_1$ and $S_3$ are computed based on $b_m$ and $b_n$ (n being a positive integer) both being equal to zero (0). Process 500 continues to block 545 where it is determined whether $S_1$ and $S_3$ are equal to zero (0). If it is determined that $S_1$ and $S_3$ are equal to zero (0), process 500 continues to block 546 where $b_m$ and $b_n$ are both set equal to zero (0). Process 500 then continues to block 580 and then to block 590.

If it is determined in block 545 that $S_1$ and $S_3$ are not equal to zero (0), process 500 continues to block 550 where $S_1$ and $S_3$ are updated based on $b_m$ being equal to one (1) and $b_n$ being equal to zero (0)s. Process 500 continues to block 551 where it is determined whether $S_1$ and $S_3$ are equal to zero (0). If it is determined in block 551 that $S_1$ and $S_3$ are equal to zero (0), process 500 continues to block 552 where $b_m$ is set equal to one (1) and $b_n$ is set equal to zero (0). Process 500 then continues to block 580 and then to block 590.

If it is determined in block 551 that $S_1$ and $S_3$ are not equal to zero (0), process 500 continues to block 560 where $S_1$ and $S_3$ are updated based on $b_m$ being equal to one (1) and $b_n$ being equal to one (1). Process 500 proceeds to block 561 where it is determined whether $S_1$ and $S_3$ are equal to zero (0). If it is determined in block 561 that $S_1$ and $S_3$ are equal to zero (0), process 500 continues to block 562 where $b_m$ and $b_n$ are both is set equal to one (1). Process 500 then continues to block 580 and then to block 590.

If it is determined in block 561 that $S_1$ and $S_3$ are not equal to zero (0), process 500 continues to block 570 where $b_m$ is set equal to zero (0) and $b_n$ is set equal to one (1). Process 500 proceeds to block 571 where it is determined whether $S_1$ and $S_3$ are equal to zero (0). If it is determined in block 571 that $S_1$ and $S_3$ are equal to zero (0), process 500 continues to block 572 where $b_m$ is set to zero (0) and $b_n$ is set equal to one (1). Process 500 then continues to block 580 and then to block 590.

In one embodiment, process 500 decodes a coded stream (e.g., a BCH coded stream) that is modulated using spread spectrum OOK. Only the first and third components of the syndrome vector ($S_1$ and $S_3$) need to be computed as opposed to conventional decoders that compute $S_2$ and $S_3$, which reduces power consumed during decoding processing.

In one embodiment, all chip level error scenarios are examined to ensure that all possible outcomes are considered. There is one particular scenario that requires careful consideration. Consider the scenario where there are two (2) errors in one spread spectrum codeword and a third one in another codeword. The two error event in one spread spectrum symbol will not be detected. As such the event will be classified as a single error case. The process 500 is configured such that this case is handled by the conventional decoder (e.g., a conventional BCH decoder), which is capable of correcting two errors.

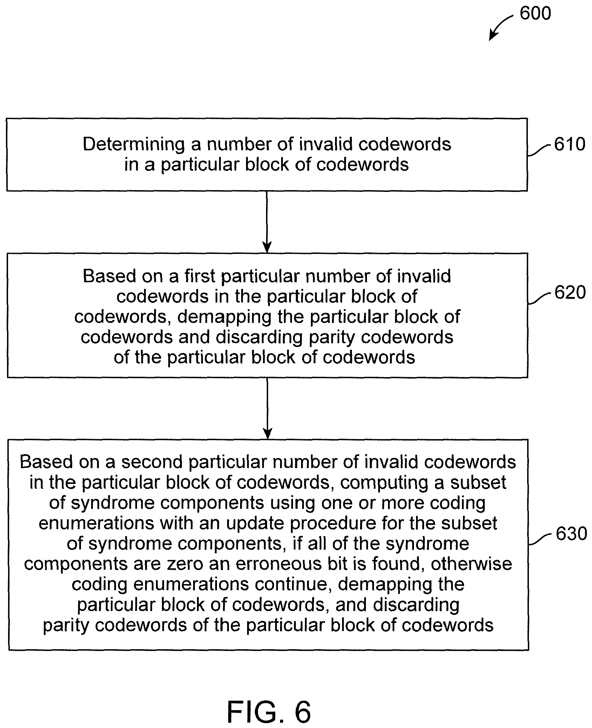

FIG. 6 shows a process 600 for information decoding, according to one embodiment. In one embodiment, process 600 proceeds by decoding, by a receiver device (e.g., receiver 400, FIG. 4), a spread spectrum coded stream of information including multiple codeword blocks. Block 610 includes determining a number of invalid codewords in a particular block of codewords. In block 620, based on a first particular number (e.g., two (2)) of invalid codewords in the particular block of codewords, process 600 demaps the particular block of codewords and discards parity codewords of the particular block of codewords. In block 630, based on a second particular number (e.g., one (1)) of invalid codewords in the particular block of codewords, process 600 computes a subset of syndrome components is computed using one or more coding enumerations with an update procedure for the subset of syndrome components, if all of the syndrome subset components are zero an erroneous bit is found, otherwise coding enumerations continue, the particular block of codewords is dempaped, and parity codewords of the particular block of codewords are discarded.

In one embodiment, process 600 may include processing based on a third particular number (e.g., zero (0)) of invalid codewords, and uses a BCH decoder to correct errors, demaps the particular block of codewords, and discards parity codewords of the particular block of codewords. In process 600, demapping may include demapping the particular block of codewords into a bit stream. Process 600 may include processing the update procedure for the subset of syndrome components based on updating the subset of syndrome components successively as needed using a single operation.

In one embodiment, in process 600 the update procedure for the subset of syndrome components may include updating the subset of syndrome components by successively updating a same syndrome equation with multiple input combinations. The component syndrome may include a vector including a 1t component, where t is a coding error correction capability. In process 600, the receiver device may comprise a wireless node that belongs to a WSN. In one embodiment, process 600 may further include receiving the spread spectrum coded stream of information from a transmitter device (e.g., transmitter 300, FIG. 3).

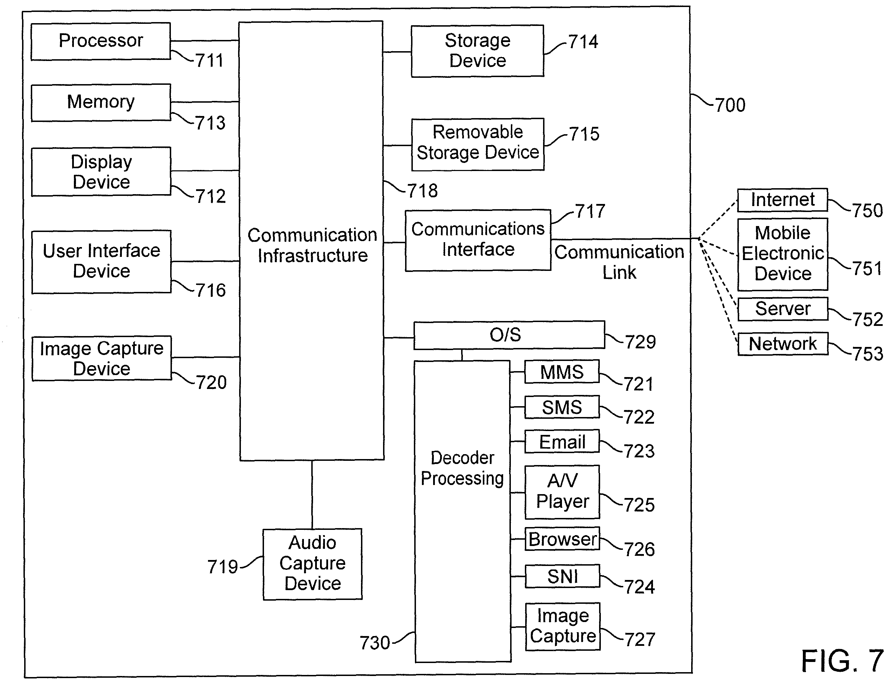

FIG. 7 is a high-level block diagram showing an information processing system comprising a computing system 700 implementing one or more embodiments. The system 700 includes one or more processors 711 (e.g., ASIC, CPU, etc.), and may further include an electronic display device 712 (for displaying graphics, text, and other data), a main memory 713 (e.g., random access memory (RAM), cache devices, etc.), storage device 714 (e.g., hard disk drive), removable storage device 715 (e.g., removable storage drive, removable memory, a magnetic tape drive, optical disk drive, computer-readable medium having stored therein computer software and/or data), user interface device 716 (e.g., keyboard, touch screen, keypad, pointing device), and a communication interface 717 (e.g., modem, wireless transceiver (such as Wi-Fi, Cellular), a network interface (such as an Ethernet card), a communications port, or a PCMCIA slot and card).

The communication interface 717 allows software and data to be transferred between the computer system and external devices through the Internet 750, mobile electronic device 751, a server 752, a network 753, etc. The system 700 further includes a communications infrastructure 718 (e.g., a communications bus, cross bar, or network) to which the aforementioned devices/interfaces 711 through 717 are connected.

The information transferred via communications interface 717 may be in the form of signals such as electronic, electromagnetic, optical, or other signals capable of being received by communications interface 717, via a communication link that carries signals and may be implemented using wire or cable, fiber optics, a phone line, a cellular phone link, an radio frequency (RF) link, and/or other communication channels.

In one implementation of one or more embodiments in a mobile wireless device (e.g., a mobile phone, smartphone, tablet, mobile computing device, wearable device, etc.), the system 700 further includes an image capture device 720, such as a camera), and an audio capture device 719, such as a microphone). The system 700 may further include application interfaces as MMS interface 721, SMS interface 722, email interface 723, social network interface (SNI) 724, audio/video (AV) player 725, web browser 726, image capture interface 727, etc.

In one embodiment, the system 700 includes decoding processing interface 730 that may implement power saving features of process 500 (FIG. 5) and processing similar as described regarding process 600 (FIG. 6). In one embodiment, the decoding processing interface 730 along with an operating system 729 may be implemented as executable code residing in a memory of the system 700. In another embodiment, the decoding processing interface 730 may be provided in hardware, firmware, etc.

As is known to those skilled in the art, the aforementioned example architectures described above, according to said architectures, can be implemented in many ways, such as program instructions for execution by a processor, as software modules, microcode, as computer program product on computer readable media, as analog/logic circuits, as application specific integrated circuits, as firmware, as consumer electronic devices, AV devices, wireless/wired transmitters, wireless/wired receivers, networks, multi-media devices, etc. Further, embodiments of said Architecture can take the form of an entirely hardware embodiment, an entirely software embodiment or an embodiment containing both hardware and software elements.

One or more embodiments have been described with reference to flowchart illustrations and/or block diagrams of methods, apparatus (systems) and computer program products according to one or more embodiments. Each block of such illustrations/diagrams, or combinations thereof, can be implemented by computer program instructions. The computer program instructions when provided to a processor produce a machine, such that the instructions, which execute via the processor create means for implementing the functions/operations specified in the flowchart and/or block diagram. Each block in the flowchart/block diagrams may represent a hardware and/or software module or logic, implementing one or more embodiments. In alternative implementations, the functions noted in the blocks may occur out of the order noted in the figures, concurrently, etc.

The terms "computer program medium," "computer usable medium," "computer readable medium", and "computer program product," are used to generally refer to media such as main memory, secondary memory, removable storage drive, a hard disk installed in hard disk drive. These computer program products are means for providing software to the computer system. The computer readable medium allows the computer system to read data, instructions, messages or message packets, and other computer readable information from the computer readable medium. The computer readable medium, for example, may include non-volatile memory, such as a floppy disk, ROM, flash memory, disk drive memory, a CD-ROM, and other permanent storage. It is useful, for example, for transporting information, such as data and computer instructions, between computer systems. Computer program instructions may be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

Computer program instructions representing the block diagram and/or flowcharts herein may be loaded onto a computer, programmable data processing apparatus, or processing devices to cause a series of operations performed thereon to produce a computer implemented process. Computer programs (i.e., computer control logic) are stored in main memory and/or secondary memory. Computer programs may also be received via a communications interface. Such computer programs, when executed, enable the computer system to perform the features of the embodiments as discussed herein. In particular, the computer programs, when executed, enable the processor and/or multi-core processor to perform the features of the computer system. Such computer programs represent controllers of the computer system. A computer program product comprises a tangible storage medium readable by a computer system and storing instructions for execution by the computer system for performing a method of one or more embodiments.

## Claims

**1.**   A method for forward error correction, FEC, decoding, comprising:

decoding, by a receiver device (400), a spread spectrum coded stream of information including a plurality of codeword blocks, each codeword constituting a spread spectrum codeword, i.e. a chip, wherein the decoding comprises:

determining (510; 610) a number of invalid spread spectrum codewords, signaling occurrence of a channel error, in a particular block of codewords;
if the number of invalid spread spectrum codewords exceeds a first particular number (520), demapping (590; 620) the particular block of codewords into a block of bits and discarding (580; 620) parity codewords of the particular block of codewords; and
if the number of invalid spread spectrum codewords exceeds a third particular number but is smaller than or equal to the first particular number (523), computing (524, 540; 630) a true subset of syndrome components using one or more Gray coding enumerations with an update procedure (527, 550, 560, 570) for the subset of syndrome components, if all of the syndrome components are zero (526, 545, 551, 561, 571) setting at least one correct bit (529, 531, 546, 552, 562, 572), demapping (590) the particular block of codewords, and discarding (580) parity codewords of the particular block of codeword; and otherwise continuing Gray coding enumeration.

**2.**   The method of claim 1, wherein the decoding further comprises:

if the number of invalid spread spectrum codewords is equal to the third particular number (521), using (522) a BCH decoder to correct errors, demapping (590) the particular block of codewords, and discarding (580) parity codewords of the particular block of codewords.

**3.**   The method of one of claims 1 or 2, wherein the update procedure (527, 550, 560, 570) for a syndrome component comprises updating the syndrome component successively as needed using a single addition, and/or wherein the update procedure (527, 550, 560, 570) for the syndrome component comprises successively updating a syndrome equation based on multiple bit combinations.

**4.**   The method of one of claims 1 to 3, wherein the syndrome comprises a vector including $2t$ components, where $t$ is a coding error correction capability.

**5.**   A receiver (400) comprising:

a decoder processor (460; 711) for forward error correction, FEC, decoding, wherein the decoder processor (460; 711) is configured to:

determine (510; 610) a number of invalid codewords, each codeword constituting a spread spectrum codeword, i.e. a chip, each invalid codeword signaling occurrence of a channel error, in a received block of codewords;
if the number of invalid spread spectrum codewords exceeds a first particular number (520), demap (590; 620) the particular block of codewords into a block of bits and discard (580; 620) parity codewords of the particular block of codewords; and

if the number of invalid spread spectrum codewords exceeds a third particular number but is smaller than or equal to the first particular number (523), compute (524, 540; 630) a true subset of syndrome components using one or more Gray coding enumerations with an update procedure (527, 550, 560, 570) for the subset of syndrome components, if all of the subset of syndrome components are zero (526, 545, 551, 561, 571) set at least one correct bit (529, 531, 546, 552, 562, 572), demap (590) the particular block of codewords, and discard (580) parity codewords of the particular block of codewords; otherwise continue Gray coding enumerations.

6. The receiver (400) of claim 5, wherein the receiver (400) receives a spread spectrum coded stream of information including a plurality of blocks of spread spectrum codewords.

7. The receiver (400) of claims 5 or 6, wherein the decoder processor (460; 711) is further configured to perform one of:

if the number of invalid spread spectrum codewords is equal to the third particular number (521), using (522) a BCH decoder to correct errors, demapping (590) the particular block of codewords, and discarding (580) parity codewords of the particular block of codewords, and

performing the update procedure (527, 550, 560, 570) for a syndrome component by updating the syndrome component successively as needed using a single addition, wherein the decoder processor (460; 711) is further configured to perform the update procedure (527, 550, 560, 570) for the syndrome component by successively updating a syndrome equation based on multiple bit combinations.

8. The receiver (400) or one of claims 5 to 7, wherein the syndrome comprises a vector including 2t components, where t is a coding error correction capability, and/or wherein the receiver (400) comprises a wireless node and belongs to a wireless sensor network, WSN (100).

9. A non-transitory computer-readable medium having instructions which when executed on a computer (700) performing a method for forward error correction, FEC, decoding, comprising:

decoding, by a processor device (711), a spread spectrum coded stream of information including a plurality of codeword blocks, each codeword constituting a spread spectrum codeword, i.e. a chip, wherein the decoding comprises:

determining (510; 610) a number of invalid spread spectrum codewords, signaling occurrence of a channel error, in a particular block of codewords;

if the number of invalid spread spectrum codewords exceeds a first particular number (520), demapping (590; 620) the particular block of codewords into a block of bits and discarding (580; 620) parity codewords of the particular block of codewords; and

if the number of invalid spread spectrum codewords exceeds a third particular number but is smaller than or equal to the first particular number (523), computing (524, 540; 630) a true subset of syndrome components using one or more Gray coding enumerations with an update procedure (527, 550, 560, 570) for the subset of syndrome components, if all of the subset of syndrome components are zero (526, 545, 551, 561, 571 setting at least one correct bit (529, 531, 546, 552, 562, 572), demapping (590) the particular block of codewords, and discarding (580) parity codewords of the particular block of codewords; otherwise Gray coding enumeration continues.

10. The medium of claim 9, wherein the decoding further comprises:

if the number of invalid spread spectrum codewords is equal to the third particular number (521), using (522) a BCH decoder to correct errors, demapping (590) the particular block of codewords, and discarding (580) parity codewords of the particular block of codewords.

11. The medium of claim 10, wherein the update procedure (527, 550, 560, 570) for a syndrome component comprises updating the syndrome component successively as needed using a single addition, and/or wherein the update procedure (527, 550, 560, 570) for the syndrome component comprises successively updating a syndrome equation based on multiple bit combinations.

12. The medium of one of claims 9 to 11, wherein the syndrome comprises a vector including 2t components, where t is a coding error correction capability.

13. The medium of one of claims 9 to 12, wherein the processor device (711) belongs to a wireless node (110) in a wireless sensor network, WSN (100).

**Patentansprüche**

1. Verfahren zur Decodierung mit Vorwärtsfehlerkorrektur, FEC, mit:

Decodieren, mittels einer Empfangseinrichtung (400), eines mit gespreizten Spektren codierten Informationsstroms mit mehreren Codewort-Blöcken, wobei jedes Codewort ein Codewort mit gespreiztem Spektrum, das heißt, eine Sequenz, bildet, wobei das Decodieren umfasst:

Ermitteln (510; 610) einer Anzahl an unzulässigen Codewörtern mit gespreiztem Spektrum, die das Auftreten eines Kanalfehlers angeben, in einem speziellen Block aus Codewörtern;
wenn die Anzahl unzulässiger Codewörter mit gespreiztem Spektrum eine erste spezielle Anzahl (520) übersteigt, Aufheben einer Zuordnung (590; 620) für den speziellen Block aus Codewörtern zur Erzeugung eines Blocks aus Bits und Verwerfen (580; 620) von Paritäts-Codewörtern des speziellen Blocks aus Codewörtern; und
wenn die Anzahl unzulässiger Codewörter mit gespreiztem Spektrum eine dritte spezielle Anzahl übersteigt aber kleiner oder gleich der ersten speziellen Anzahl (523) ist, Berechnen (524, 540; 630) einer wahren Teilmenge aus Syndrom-Komponenten unter Anwendung einer oder mehrerer Gray-Codierungsaufzählungen mit einer Aktualisierungsprozedur (527, 550, 560, 570) für die Teilmenge aus Syndrom-Komponenten, wenn alle Syndrom-Komponenten gleich Null sind (526,545, 551, 561, 571), Setzen mindestens eines Korrektur-Bits (529, 531, 546, 552, 562, 572), Aufheben der Zuordnung (590) für den speziellen Block aus Codewörtern und Verwerfen (580) von Paritäts-Codewörtern des speziellen Blocks aus Codewörtern; und ansonsten Fortsetzen der Gray-Codierungsaufzählung.

2. Verfahren nach Anspruch 1, wobei das Decodieren ferner umfasst:

wenn die Anzahl unzulässiger Codewörter mit gespreiztem Spektrum gleich der dritten speziellen Anzahl (521) ist, Verwenden (522) eines BCH-Decodierers zur Korrektur von Fehlern, Aufheben der Zuordnung (590) für den speziellen Block aus Codewörtern und Verwerfen (580) von Paritäts-Codewörtern des speziellen Blocks aus Codewörtern.

3. Verfahren nach einem der Ansprüche 1 oder 2, wobei die Aktualisierungsprozedur (527, 550, 560, 570) für eine Syndrom-Komponente umfasst: sukzessives Aktualisieren der Syndrom-Komponente nach Bedarf unter Anwendung einer einzigen Addition und/oder wobei die Aktualisierungsprozedur (527, 550, 560, 570) für die Syndrom-Komponente umfasst: sukzessives Aktualisieren einer Syndrom-Gleichung auf der Grundlage mehrerer Bit-Kombinationen.

4. Verfahren nach einem der Ansprüche 1 bis 3, wobei die Syndrom-Komponente einen Vektor enthält, der 2 t Komponenten enthält, wobei t eine Codierungsfehlerkorrekturkapazität ist.

5. Empfänger (400), mit:

einem Decodier-Prozessor (460; 711) zum Decodieren mit Vorwärtsfehlerkorrektur, FEC, wobei der Decodier-Prozessor (460; 711) ausgebildet ist, um:

eine Anzahl unzulässiger Codewörter zu ermitteln (510; 610), wobei jedes Codewort ein Codewort mit gespreiztem Spektrum, das heißt, eine Sequenz, bildet, wobei jedes unzulässige Codewort das Auftreten eines Kanalfehlers in einem empfangenen Block aus Codewörtern angibt;
wenn die Anzahl unzulässiger Codewörter mit gespreiztem Spektrum eine erste spezielle Anzahl (520) übersteigt, für den speziellen Block aus Codewörtern eine Zuordnung aufzuheben (590; 620), um einen Block aus Bits zu erzeugen, und Paritäts-Codewörter des speziellen Blocks aus Codewörtern zu verwerfen (580; 620); und
wenn die Anzahl unzulässiger Codewörter mit gespreiztem Spektrum eine dritte spezielle Anzahl übersteigt,

aber kleiner oder gleich der ersten speziellen Anzahl (523) ist, eine wahre Teilmenge an Syndrom-Komponenten zu berechnen (524, 540; 630) unter Anwendung einer oder mehreren Gray-Codierungsaufzählungen mit einer Aktualisierungsprozedur (527, 550, 560, 570) für die Teilmenge aus Syndrom-Komponenten, wenn alle Syndrom-Komponenten der Teilmenge Null sind (526, 545, 551, 561, 571), mindestens ein Korrektur-Bit (529, 531, 546, 552, 562, 572) zu setzen, für den speziellen Block aus Codewörtern eine Zuordnung aufzuheben (590) und Paritäts-Codewörter des speziellen Blocks aus Codewörtern zu verwerfen (580); ansonsten Gray-Codierungsaufzählungen fortzusetzen.

6. Empfänger (400) nach Anspruch 5, wobei der Empfänger (400) einen Informationsstrom, der mit gespreiztem Spektrum codiert ist, empfängt, der mehrere Blöcke aus Codewörtern mit gespreiztem Spektrum enthält.

7. Empfänger (400) nach Anspruch 5 oder 6, wobei der Decodier-Prozessor (460; 711) ferner ausgebildet ist, um auszuführen:

   wenn die Anzahl unzulässiger Codewörter mit gespreiztem Spektrum gleich der dritten speziellen Anzahl (521) ist, Verwenden (522) eines BCH-Decodierers zur Korrektur von Fehlern, Aufheben einer Zuordnung (590) für den speziellen Block aus Codewörtern und Verwerfen (580) von Paritäts-Codewörtern des speziellen Blocks aus Codewörtern, oder
   Ausführen der Aktualisierungsprozedur (527, 550, 560, 570) für eine Syndrom-Komponente durch sukzessives Aktualisieren der Syndrom-Komponente nach Bedarf unter Anwendung einer einzigen Addition, wobei der Decodier-Prozessor (460; 711) ferner ausgebildet ist, die Aktualisierungsprozedur (527, 550, 560, 570) für die Syndrom-Komponente auszuführen, indem eine Syndrom-Gleichung auf der Grundlage mehrerer Bit-Kombinationen sukzessiv aktualisiert wird.

8. Empfänger (400) nach einem der Ansprüche 5 bis 7, wobei die Syndrom-Komponente einen Vektor mit 2 t Komponenten enthält, wobei t eine Codierungsfehlerkorrekturkapazität ist, und/oder wobei der Empfänger (400) einen drahtlosen Knoten umfasst und zu einem drahtlosen Sensor-Netzwerk, WSN (100), gehört.

9. Nicht-flüchtiges computerlesbares Medium mit Befehlen, die, wenn sie in einem Computer (700) ausgeführt werden, ein Verfahren zum Decodieren mit Vorwärtsfehlerkorrektur, FEC, ausführen, mit:

   Decodieren, mittels einer Prozessoreinrichtung (711), eines Informationsstroms, der mit gespreiztem Spektrum codiert ist und mehrere Codewort-Blöcke enthält, wobei jedes Codewort ein Codewort mit gespreiztem Spektrum, das heißt, eine Sequenz, bildet, wobei das Decodieren umfasst:

   Ermitteln (510; 610) einer Anzahl an unzulässigen Codewörtern mit gespreiztem Spektrum in einem speziellen Block aus Codewörtern, wodurch das Auftreten eines Kanalfehlers angegeben wird;
   wenn die Anzahl unzulässiger Codewörter mit gespreiztem Spektrum eine erste spezielle Anzahl (520) übersteigt, Aufheben der Zuordnung (590; 620) für den speziellen Block aus Codewörtern zur Erzeugung eines Blocks aus Bits und Verwerfen (580; 620) von Paritäts-Codewörtern des speziellen Blocks aus Codewörtern; und
   wenn die Anzahl an unzulässigen Codewörtern mit gespreiztem Spektrum eine dritte spezielle Anzahl übersteigt, aber kleiner oder gleich der ersten speziellen Anzahl (523) ist, Berechnen (524, 540; 630) einer wahren Teilmenge aus Syndrom-Komponenten unter Anwendung einer oder mehrerer Gray-Codierungsaufzählungen mit einer Aktualisierungsprozedur (527, 550, 560, 570) für die Teilmenge aus Syndrom-Komponenten, wenn alle aus der Teilmenge aus Syndrom-Komponenten Null sind (526, 545, 551, 561, 571), Setzen mindestens eines Korrektur-Bits (529, 531, 546, 552, 562, 572), Aufheben der Zuordnung (590) für den speziellen Block aus Codewörtern und Verwerfen (580) von Paritäts-Codewörtern des speziellen Blocks aus Codewörtern; ansonsten Fortsetzen der Gray-Codierungsaufzählung.

10. Medium nach Anspruch 9, wobei das Decodieren ferner umfasst: wenn die Anzahl an unzulässigen Codewörter mit gespreiztem Spektrum gleich der dritten speziellen Anzahl ist (521), Verwenden (522) eines BCH-Decodierers zur Korrektur von Fehlern, Aufheben der Zuordnung (590) für den speziellen Block aus Codewörtern und Verwerfen (580) von Paritäts-Codewörtern des speziellen Blocks aus Codewörtern.

11. Medium nach Anspruch 10, wobei die Aktualisierungsprozedur (527, 550, 560, 570) für eine Syndrom-Komponente umfasst: sukzessives Aktualisieren der Syndrom-Komponente nach Bedarf unter Anwendung einer einzigen Addition und/oder

wobei die Aktualisierungsprozedur (527, 550, 560, 570) für die Syndrom-Komponente umfasst: sukzessives Aktualisieren einer Syndrom-Gleichung auf der Grundlage mehrerer Bit-Kombinationen.

12. Medium nach einem der Ansprüche 9 bis 11, wobei die Syndrom-Komponente einen Vektor mit 2 t Komponenten enthält, wobei t eine Codierfehlerkorrekturkapazität ist.

13. Medium nach einem der Ansprüche 9 bis 12, wobei die Prozessoreinrichtung (711) zu einem drahtlosen Knoten (110) in einem drahtlosen Sensor-Netzwerk, WSN, (100) gehört.

**Revendications**

1. Procédé de décodage de correction d'erreur directe FEC, soit Forward Error Correction, comprenant :

le décodage, par un dispositif récepteur (400), d'un flux d'information codé à spectre étalé incluant une pluralité de blocs de mots de code, chaque mot de code constituant un mot de code à spectre étalé, c'est-à-dire un chip, dans lequel le décodage comprend :

la détermination (510 ; 610) d'un nombre de mots de code à spectre étalé non valides ;
la signalisation de l'occurrence d'une erreur de canal, dans un bloc particulier de mots de code ;
si le nombre de mots de code à spectre étalé non valides est supérieur à un premier nombre particulier (520), le démappage (590 ; 620) du bloc particulier de mots de code en un bloc de bits et l'élimination (580 ; 620) de mots de code de parité du bloc particulier de mots de code ; et
si le nombre de mots de code à spectre étalé non valides est supérieur à un troisième nombre particulier mais inférieur ou égal au premier nombre particulier (523), le calcul (524, 540 ; 630) d'un vrai sous-ensemble de composantes de syndrome en utilisant une ou plusieurs énumérations de codage de Gray avec une procédure d'actualisation (527, 550, 560, 570) pour le sous-ensemble de composantes de syndrome, si toutes les composantes de syndrome sont nulles (526, 545, 551, 561, 571), l'établissement d'au moins un bit correct (529, 531, 546, 552, 562, 572), le démappage (590) du bloc particulier de mots de code, et l'élimination (580) de mots de code de parité du bloc particulier de mots de code ; et autrement la continuation de l'énumération du codage de Gray.

2. Procédé selon la revendication 1, dans lequel le décodage comprend en outre :

si le nombre de mots de code à spectre étalé non valides est égal au troisième nombre particulier (521), l'utilisation (522) d'un décodeur BCH pour corriger les erreurs, le démappage (590) du bloc particulier de mots de code, et l'élimination (580) de mots de code de parité du bloc particulier de mots de code.

3. Procédé selon l'une des revendications 1 ou 2, dans lequel la procédure d'actualisation (527, 550, 560, 570) pour une composante de syndrome comprend l'actualisation de la composante de syndrome successivement selon les besoins en utilisant une addition unique, et/ou dans lequel la procédure d'actualisation (527, 550, 560, 570) pour la composante de syndrome comprend l'actualisation successivement d'une équation de syndrome sur base de multiples combinaisons binaires.

4. Procédé selon l'une des revendications 1 à 3, dans lequel le syndrome comprend un vecteur incluant 2t composantes, où t est une capacité de correction d'erreur de codage.

5. Récepteur (400) comprenant :

un processeur de décodeur (460 ; 711) pour un décodage de correction d'erreur directe FEC, dans lequel le processeur de décodeur (460 ; 711) est configuré pour :

déterminer (510 ; 610) un nombre de mots de code non valides, chaque mot de code constituant un mot de code à spectre étalé, c'est-à-dire un chip, chaque mot de code non valide signalant l'occurrence d'une erreur de canal, dans un bloc de mots de code reçu ;
si le nombre de mots de code à spectre étalé non valides dépasse un premier nombre particulier (520), démapper (590 ; 620) le bloc particulier de mots de code en un bloc de bits et éliminer (580 ; 620) des mots de code de parité du bloc particulier de mots de code ; et

si le nombre de mots de code à spectre étalé non valides est supérieur à un troisième nombre particulier mais inférieur ou égal au premier nombre particulier (523), calculer (524, 540 ; 630) d'un vrai sous-ensemble de composantes de syndrome en utilisant une ou plusieurs énumérations de codage de Gray avec une procédure d'actualisation (527, 550, 560, 570) pour le sous-ensemble de composantes de syndrome, si toutes les composantes du sous-ensemble de composantes de syndrome sont nulles (526, 545, 551, 561, 571), établir au moins un bit correct (529, 531, 546, 552, 562, 572), démapper (590) le bloc particulier de mots de code, et éliminer (580) des mots de code de parité du bloc particulier de mots de code ; et autrement continuer des énumérations de codage de Gray.

6. Récepteur (400) selon la revendication 5, dans lequel le récepteur (400) reçoit un flux d'information codé par le spectre étalé incluant une pluralité de blocs de mots de code à spectre étalé.

7. Récepteur (400) selon la revendication 5 ou 6, dans lequel le processeur de décodeur (460 ; 711) est en outre configuré pour mettre en oeuvre une opération parmi :

si le nombre de mots de code à spectre étalé non valides est égal au troisième nombre particulier (521), l'utilisation (522) d'un décodeur BCH pour corriger les erreurs, le démappage (590) du bloc particulier de mots de code, et l'élimination (580) de mots de code de parité du bloc particulier de mots de code, et la mise en oeuvre de la procédure d'actualisation (527, 550, 560, 570) pour une composante de syndrome en actualisant la composante de syndrome successivement selon les besoins en utilisant une addition unique, dans lequel le processeur de décodeur (460 ; 711) est en outre configuré pour mettre en oeuvre la procédure d'actualisation (527, 550, 560, 570) pour la composante de syndrome en actualisant successivement une équation de syndrome sur base de multiples combinaisons binaires.

8. Récepteur (400) selon l'une des revendications 5 à 7, dans lequel le syndrome comprend un vecteur incluant 2t composantes, où t est une capacité de correction d'erreur de codage. et/ou dans lequel le récepteur (400) comprend un noeud sans fil et appartient à un réseau de capteurs sans fil WSN (100), soit Wireless Sensor Network.

9. Support non volatile lisible par un ordinateur comportant des instructions qui, quand elles sont exécutées sur un ordinateur (700) mettant en oeuvre un procédé de décodage de correction d'erreur directe FEC, comprennent :

le décodage, par un dispositif processeur (711), d'un flux d'information codé à spectre étalé incluant une pluralité de blocs de mots de code, chaque mot de code constituant un mot de code à spectre étalé, c'est-à-dire un chip, dans lequel le décodage comprend :

la détermination (510 ; 610) d'un nombre de mots de code à spectre étalé non valides, la signalisation de l'occurrence d'une erreur de canal, dans un bloc particulier de mots de code ; si le nombre de mots de code à spectre étalé non valides est supérieur à un premier nombre particulier (520), le démappage (590 ; 620) du bloc particulier de mots de code en un bloc de bits, et l'élimination (580 ; 620) de mots de code de parité du bloc particulier de mots de code ; et si le nombre de mots de code à spectre étalé non valides est supérieur à un troisième nombre particulier mais inférieur ou égal au premier nombre particulier (523), le calcul (524, 540 ; 630) d'un vrai sous-ensemble de composantes de syndrome en utilisant une ou plusieurs énumérations de codage de Gray avec une procédure d'actualisation (527, 550, 560, 570) pour le sous-ensemble de composantes de syndrome, si toutes les composantes du sous-ensemble de composantes de syndrome sont nulles (526, 545, 551, 561, 571), l'établissement d'au moins un bit correct (529, 531, 546, 552, 562, 572), le démappage (590) du bloc particulier de mots de code, et l'élimination (580) de mots de code de parité du bloc particulier de mots de code ; autrement, l'énumération du codage de Gray continue.

10. Support selon la revendication 9, dans lequel le décodage comprend en outre :

si le nombre de mots de code à spectre étalé non valides est égal au troisième nombre particulier (521), l'utilisation (522) d'un décodeur BCH pour corriger les erreurs, le démappage (590) du bloc particulier de mots de code, et l'élimination (580) de mots de code de parité du bloc particulier de mots de code.

11. Support selon la revendication 10, dans lequel la procédure d'actualisation (527, 550, 560, 570) pour une composante de syndrome comprend l'actualisation de la composante de syndrome successivement selon les besoins en utilisant une addition unique, et/ou dans lequel la procédure d'actualisation (527, 550, 560, 570) pour la composante de syndrome comprend l'actualisation successivement d'une équation de syndrome sur base de multiples combinaisons binaires.

12. Support selon l'une des revendications 9 à 11, dans lequel le syndrome comprend un vecteur incluant 2t composantes, où t est une capacité de correction d'erreur de codage.

13. Support selon l'une des revendications 9 à 12, dans lequel le dispositif processeur (711) appartient à un noeud sans fil (110) dans un réseau de capteurs sans fil WSN (100).

100

110

Base Station    120

FIG. 1

| | | |
|---|---|---|
| 210 | 230 | 260 |
| Location System | Communication System | Operating System |
| 220 | 240 | 270 |
| Mobilize Interface | Sensor Interface | Applications |
| | 250 | 280 |
| | Power | Transceiver System |

FIG. 2

EP 2 916 460 B1

EP 2 916 460 B1

*300*

Uncoded Data → | Shortened BCH 310 | → | Bit-level interleaving 320 | → | Bits-to-symbol conversion 330 |

→ | Symbol-to-chip mapper 340 | → | Random sequence inversion 350 | → | Pulse shaping 360 | →

Preamble + SFD

## FIG. 3

*400*

→ | Energy Detection 410 | → | Timing Synchronization 420 | → | Frame & Fine Synchronization 430 | → | Demodulator 440 | → | De-Inter leaver 450 | → | Decoder 460 | →

## FIG. 4

FIG. 5

600

| Determining a number of invalid codewords in a particular block of codewords | 610 |

| Based on a first particular number of invalid codewords in the particular block of codewords, demapping the particular block of codewords and discarding parity codewords of the particular block of codewords | 620 |

| Based on a second particular number of invalid codewords in the particular block of codewords, computing a subset of syndrome components using one or more coding enumerations with an update procedure for the subset of syndrome components, if all of the syndrome components are zero an erroneous bit is found, otherwise coding enumerations continue, demapping the particular block of codewords, and discarding parity codewords of the particular block of codewords | 630 |

## FIG. 6

FIG. 7

EP 2 916 460 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 2008046799 A1, Geller Benoit

**Non-patent literature cited in the description**

• **KIRAN BYNAM.** Samsung's_Physical_Layer_Proposal ; 15-13-0623-00-004q-samsung-s-physical-layer-proposal. *IEEE draft, IEEE-SA mentor,* 31 October 2013, vol. 802 (15), 1-25

• **KIM JEONG GON ; KIM HYUNG-MYUNG.** Adaptive Decoding Scheme for Concatenated Codes in Frequency-Hopped Spread-Spectrum Communications with a Pulse-Burst Jamming. *IEICE Transactions on Communications,* April 1996, vol. E79B (4), 578-586